# EUROPEAN PATENT APPLICATION

(11) **EP 2 103 950 A1**
(43) Date of publication of application: **23.09.2009**
(21) Application number: 09003964.5
(22) Date of filing: 19.03.2009
(51) Int. Cl.: G01R 31/01

(54) **Method for inspecting insulation property of capacitor**

(30) Priority: 19.03.2008 JP 2008071595
(71) Applicant: HUMO LABORATORY, LTD., Tokyo 167-0042 (JP)
(72) Inventor: Nonaka, Satoshi, Hamamatsu-shi, Shizuoka, 431-1300 (JP); Kubo, Yoshinori, Hamamatsu-shi, Shizuoka, 431-1300 (JP)
(74) Representative: Banzer, Hans-Jörg

(57) **Abstract**

A method for inspecting an insulation property of a capacitor, comprises the steps of: applying a DC voltage V₁ higher than a voltage V₀ to a capacitor to be inspected, in which the voltage V₀ is predetermined for inspection of the insulation property of the capacitor, to generate an electric current in the capacitor; lowering the DC voltage V₁ to the voltage V₀ at a lapse of a time t₁, to convert the electric current in the capacitor into a continuously unvaried electric current; determining a value i₀ of the continuously unvaried electric current; and comparing the value i₀ with an upper limit of a leakage current which is predetermined for the capacitor.

## Description

### FIELD OF THE INVENTION

The present invention relates to a method for inspecting an insulation property of a capacitor.

### BACKGROUND OF THE INVENTION

Recently, electric devices (such as capacitors) of an extremely small size are requested in industry so that the electric devices can be mounted onto a circuit board with a high density. However, there is a problem that a capacitor of an extremely small size sometimes shows poor insulation property. Therefore, it is common that all of capacitors manufactured in industry are inspected in advance of their practical uses.

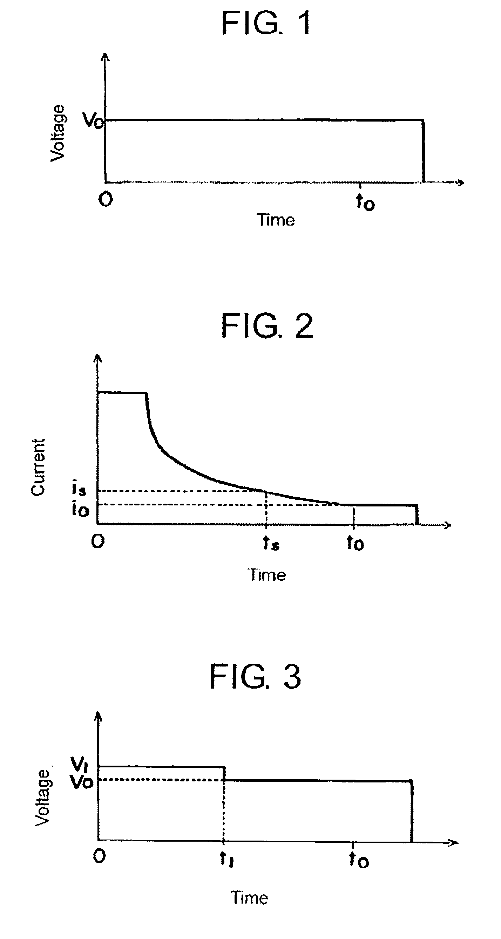

Fig. 1 schematically shows a wave pattern of a direct current voltage (DC voltage) which is applied to a capacitor to be inspected in a conventional inspection method. Fig. 2 schematically shows an electric current generated in the capacitor after the application of the DC voltage shown in Fig. 1.

Until now, there are known two methods, namely the below-described methods (A) and (B), for the inspection of an insulation property of capacitors.

### Method (A)

A direct current voltage V₀ is applied to a capacitor to be inspected, in which the direct current voltage V₀ is predetermined for inspection of an insulation property of the capacitor, to generate an electric current in the capacitor. When an unvaried electric current is observed in the current flowing in the capacitor at a lapse of a time t₀, the value of i₀ of the unvaried electric current is determined. The value (leakage current value) i₀ is then compared with a predetermined upper limit i_{OH} of the leakage current, to evaluate the insulation property of the capacitor. If the value i₀ exceeds the upper limit i_{0H}, the capacitor having been inspected is rejected.

It is known, however that there is a problem in the above-mentioned inspection method in that the time t₀ when the unvaried electric current in the capacitor occurs is generally from approx. one minute to 5 minutes after the application of the direct current voltage. Accordingly, although the above-mentioned method can evaluate the insulation property of a capacitor with high accuracy, the inspection necessarily requires a long period of time if a great number of capacitors should be inspected.

In the above-mentioned method, the above-mentioned voltage V₀ is set at a value of 0.1 to 5 times, preferably 0.1 to 1 time, as much as the rated voltage of the capacitor, and the time t₀ is set from one minute to 5 minutes, though the V₀ and t₀ may be determined depending on the specification of the capacitor to be inspected.

The upper limit i_{0H} of the leakage current is generally determined by the following method. A direct current voltage V₀ is applied to a referential capacitor of the same specification as the capacitor to be inspected, and a value of an electric current flowing in the capacitor at a lapse of time to after the application of the direct current voltage is measured. The upper limit i_{0H} is set at a value from 1.1 to 2.0 times, preferably 1.1 to 1.5 times, as much as the measured value. If required, the above-mentioned determination method is repeated for a plurality of capacitors (e.g., 5 to 100 capacitors) of the same specification as the capacitor to be inspected, and the measured values are averaged to determine the upper limit i_{0H}.

It is generally accepted that the leakage current of capacitors should be as little as possible. However, it is sometimes desired that a group of capacitors have a leakage characteristic equivalent to each other. In this case, the obtained current value (leakage current value) i₀ is generally compared with a predetermined lower limit (i_{0L}) of the leakage current. The comparison of i₀ with i_{0L} is also effective to check whether or not the ampere meter works correctly.

The lower limit i_{0L} of the leakage current is generally determined by the following method. A direct current voltage V₀ is applied to a referential capacitor of the same specification as the capacitor to be inspected, and a value of an electric current flowing in the capacitor at a lapse of time t₀ after the application of the direct current voltage is measured. The lower limit i_{0L} is set at a value from 0.1 to 0.9 time, preferably 0.5 to 0.9 time, as much as the measured value. If required, the above-mentioned determination method is repeated for a plurality of capacitors (e.g., 5 to 100 capacitors) of the same specification as the capacitor to be inspected, and the measured values are averaged to determine the lower limit i_{0L}.

### Method (B)

A direct current voltage V₀ is applied to a capacitor to be inspected, in which the direct current voltage V₀ is predetermined for inspection of an insulation property of the capacitor, to generate an electric current in the capacitor. At a lapse of time tₛ which is shorter than the aforementioned t₀, a value iₛ of a current flowing in the capacitor is determined. The value iₛ is then compared with a predetermined upper limit i_{sH} of the leakage current, to evaluate the insulation property of the capacitor. If the value iₛ exceeds the upper limit i_{sH}, the capacitor having been inspected is rejected. This judgement is made based on such assumption that an inspected capacitor showing a value iₛ exceeding the upper limit i_{sH} at a lapse of time tₛ will show iₒ exceeding the upper limit i_{0H} when the time t₀ lapses.

The above-mentioned method (B) is advantageous in that the inspection of an insulation property of capacitors can be completed within a period of time shorter than the period of time required for performing the aforementioned method (A). However, since the current value iₛ is determined prior to the time to when the electric current flowing in the capacitor stabilizes, that is, the determination is performed under such conditions that the value of the electric current flowing in the capacitor still varies or decreases as a lapse of time, it is sometimes difficult to obtain a correct current value iₛ if the time for determining the current value iₛ is not set very precisely. Moreover, if the time for determining the current value iₛ is set to be shorter so as to shorten the period required for the inspection of a capacitor, a value of the electric current flowing in the capacitor varies greatly at a lapse of time and the determined value may fluctuate in an increased wide range. This means that the accuracy of inspection lowers.

In the method (B), the above-mentioned time tₛ is generally set to a time within 0.01 to 90% per the time t₀, depending on the specification of the capacitor to be inspected. However, if the inspection with high accuracy is desired, the time tₛ should not be so short. The current voltage V₀ to be applied to a capacitor to be inspected is predetermined in the same manner as in the aforementioned method (A).

The upper limit i_{sH} of the leakage current is generally determined by the following method. A direct current voltage V₀ is applied to a referential capacitor of the same specification as the capacitor to be inspected, and a value of an electric current flowing in the capacitor at a lapse of time tₛ after the application of the direct current voltage is measured. The upper limit i_{sH} is set at a value from 1.1 to 2.0 times, preferably 1.1 to 1.5 times, as much as the measured value. If required, the above-mentioned determination method is repeated for a plurality of capacitors (e.g., 5 to 100 capacitors) of the same specification as the capacitor to be inspected, and the measured values are averaged to determine the upper limit i_{sH}.

If the determined current value iₛ should be compared with a predetermined lower limit i_{sL} as is in the method (A), the lower limit i_{sL} of the leakage current is generally determined by the following method. A direct current voltage V₀ is applied to a referential capacitor of the same specification as the capacitor to be inspected, and a value of an electric current flowing in the capacitor at a lapse of time tₛ after the application of the direct current voltage is measured. The lower limit i_{sL} is set at a value from 0.1 to 0.9 time, preferably 0.5 to 0.9 time, as much as the measured value. If required, the above-mentioned determination method is repeated for a plurality of capacitors (e.g., 5 to 100 capacitors) of the same specification as the capacitor to be inspected, and the measured values are averaged to determine the lower limit i_{sL}.

Japanese Patent Provisional Publication 11-212777 (JP 11-211777A) discloses a method for inspecting an insulation property (method for judging whether capacitors are acceptable or failed) which is based on a gradient of a waveform of an electric current flowing in a capacitor (charging current characteristics) which is obtained prior to t₀ at which the stable current is observed.

In the above-mentioned method, the insulation property of the capacitor is inspected, for instance, by obtaining a gradient of the waveform of the current at two points of time and examining whether or not the difference between the two gradients is a value between the predetermined upper limit and lower limit.

The patent publication indicates that the disclosed inspection method enables to inspect the insulation property of capacitors with high accuracy in a shortened period of time.

However, there probably is a problem in that the accuracy of the inspection likely lowers due to possible errors occurring in the determination of the gradients of the current waveform unless the time for measuring the gradients is precisely set, because the gradients are measured prior to the time t₀ when the electric current flowing in the capacitor stabilizes. The accuracy further lowers if the period of time for measuring the gradients of the current waveform is shortened for shortening the period required for the inspection. This is because the electric current greatly varies and hence the gradients measured under the condition greatly varies.

In addition, the disclosed method requires complicated mathematic processing such as differential processing for obtaining the gradient of the current waveform and subtraction between the measured gradients.

### SUMMARY OF THE INVENTION

It is an object of the invention to provide a simple method for inspecting an insulation property of capacitors with high accuracy in a shortened period of time.

The present inventors have discovered that an electric current (charging current) flowing in a capacitor by application of a direct current voltage becomes a continuously unvaried electric current when a discharge current produced in the capacitor by decreasing the direct current voltage is decreased and that the inspection of a capacitor for determination of its insulation property can be made with high accuracy in a shortened period of time.

The present invention relates to a method for inspecting an insulation property of a capacitor as defined in claim 1. The dependent claims define preferred embodiments of the invention.

Accordingly, the present invention resides in a method for inspecting insulation property of a capacitor, which comprises the steps of:
applying a direct current voltage V₁ higher than a voltage V₀ to a capacitor to be inspected, said voltage V₀ being predetermined for inspection of insulation property of the capacitor, whereby generating an electric current in the capacitor;
lowering the direct current voltage V₁ to the voltage V₀ at a lapse of a time t₁, whereby converting the electric current in the capacitor into a continuously unvaried electric current;
determining a value i₀ of the continuously unvaried electric current; and
comparing the value i₀ with an upper limit of a leakage current which is predetermined for the capacitor to be inspected,
provided that if the continuously unvaried electric current is observed twice or more after the lowering of the direct current voltage, a value iₛ of the first con-tinuously unvaried electric current is compared with an upper limit of a leakage current-relating value which is predetermined for the capacitor to be inspected.

The inspection method of the invention may further comprises the step of comparing the value i₀ with a lower limit of a leakage current which is predetermined for the capacitor to be inspected,
provided that if the continuously unvaried electric current is observed twice or more after the lowering of the direct current voltage, a value iₛ of the first continuously unvaried electric current is compared with a lower limit of a leakage current-relating value which is predetermined for the capacitor to be inspected.

In the inspection method of the invention, the direct current voltage V₁ and the time t₁ may be determined by a method comprising the steps of:
applying an optionally determined direct current, voltage V₂ higher than the voltage V₀ to a referential capacitor, whereby generating an electric current in the referential capacitor;
lowering the direct current voltage V₂ to the voltage V₀ at a lapse of an optionally determined time t₂, and detecting a pattern of an electric current flowing in the referential capacitor;
repeating a combination of the above-mentioned steps to find a combination of a direct current voltage V₂ and a time t₂ to give a pattern having a continuously unvaried electric current; and
allotting the found combination of a direct current voltage V₂ and a time t₂ to a combination of the direct current voltage V₁ and the time t₁.

In the inspection method of the invention, the comparison between the determined current value i₀ (or iₛ) and the predetermined upper limit i_{0H} (or i_{sH}) can be performed using relating values, for instance, by comparing a resistance value converted from the current value i₀ (or iₛ) and a resistance value converted from the predetermined upper limit i_{0H} (or i_{sH}) using the value of the direct current voltage applied to the capacitor.

In the same way, the comparison between the determined current value i₀ (or iₛ) and the predetermined lower limit i_{0L} (or i_{sL}) can be performed using relating values, for instance, by comparing a resistance value converted from the current value i₀ (or iₛ) and a resistance value converted from the predetermined lower limit i_{0L} (or i_{sL}) using the value of the direct current voltage applied to the capacitor.

Therefore, the present invention provides a simple method for inspecting an insulation property of capacitors in a shortened period of time, which can be performed by applying a direct current voltage to a capacitor to be inspected; subsequently decreasing the direct current voltage; and determining the value of a continuously unvaried current flowing in the capacitor which is produced by the decrease of the direct current voltage.

Further, the inspection method of the invention enables to inspect an insulation property of the capacitor with high accuracy, because the value of an electric current is determined on the continuously unvaried current and the value of the continuously unvaried current does not greatly vary when the time of the determination of the current value slightly deviates.

### BRIEF DESCRIPTION OF THE DRAWINGS

Fig. 1 schematically shows a waveform of a direct current voltage applied to a capacitor to be inspected in the conventional inspection method.
Fig. 2 schematically shows a waveform of an electric current flowing in the capacitor by the application of the direct current voltage shown in Fig. 1.
Fig. 3 schematically shows an example of a waveform of a direct current voltage applied to a capacitor to be inspected in the inspection method of the invention.
Fig. 4 schematically shows an example of a waveform of an electric current flowing in the capacitor by the application of the direct current voltage shown in Fig. 3.
Fig. 5 schematically shows another example of the waveform of a direct current voltage applied to a capacitor to be inspected in the inspection method of the invention.
Fig. 6 schematically shows another example of the waveform of an electric current flowing in the capacitor by the application of the direct current voltage shown in Fig. 5.
Fig. 7 schematically shows a further example of the waveform of a direct current voltage applied to a capacitor to be inspected in the inspection method of the invention.
Fig. 8 schematically shows a further example of the waveform of an electric current flowing in the capacitor by the application of the direct current voltage shown in Fig. 7.
Fig. 9 schematically shows a still further example of the waveform of a direct current voltage applied to a capacitor to be inspected in the inspection method of the invention.
Fig. 10 schematically shows a still further example of the waveform of an electric current flowing in the capacitor by the application of the direct current voltage shown in Fig. 9.
Fig. 11 shows a waveform of a direct current voltage applied to a capacitor to be inspected in the inspection method for comparison, which is observed in the comparison example.
Fig. 12 shows a waveform of an electric current flowing in the capacitor by the application of the direct current voltage shown in Fig. 11.
Fig. 13 shows a waveform of a direct current voltage applied to a capacitor to be inspected in the inspection method, which is observed in the working example according to the invention.
Fig. 14 shows a waveform of an electric current flowing in the capacitor by the application of the direct current voltage shown in Fig. 13.

### DETAILED DESCRIPTION OF THE INVENTION

The inspection method of the invention is further described referring to the figures illustrated in the attached drawings.

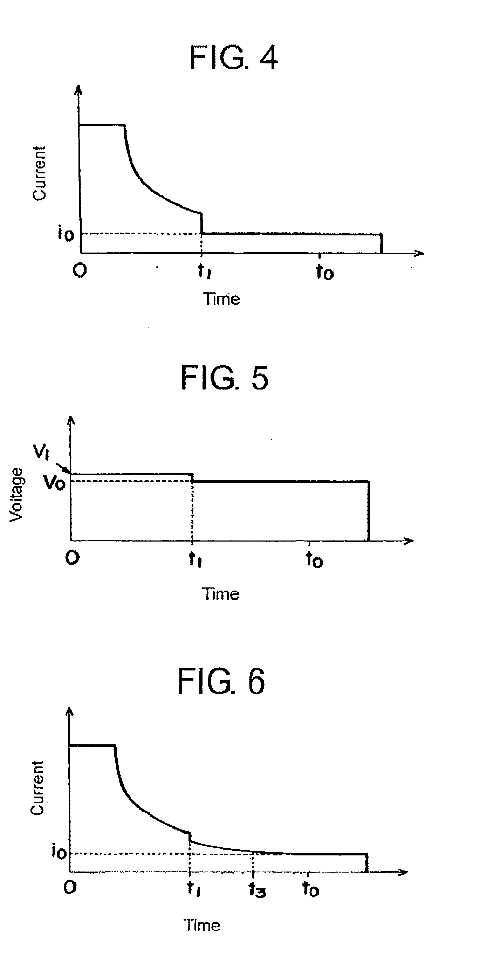

Fig. 3 schematically shows an example of a waveform of a direct current voltage applied to a capacitor to be inspected in the inspection method of the invention, and Fig. 4 schematically shows an example of a waveform of an electric current flowing in the capacitor by the application of the direct current voltage shown in Fig. 3.

As shown in figures 3 and 4, the method of the invention is performed by the sequential steps of applying a direct current voltage V₁ higher than a voltage V₀ to a capacitor to be inspected, in which the direct current voltage V₁ is predetermined for inspection of insulation property of the capacitor, whereby generating an electric current in the capacitor; lowering the direct current voltage V₁ to the voltage V₀ at a lapse of a time t₁, whereby converting the electric current in the capacitor into a continuously unvaried electric current; determining a value i₀ of the continuously unvaried electric current; and comparing the value i₀ with an upper limit of a leakage current which is predetermined for the capacitor to be inspected.

By the comparison, if the capacitor shows a current value i₀ exceeding the upper limit i_{0H} of the leakage current, the capacitor is rejected.

In other words, according to the inspection method of the invention, a charged electric current (which is varied as a lapse of time) flowing in the capacitor which is produced by the application of a direct current V₁ to a capacitor to be inspected is converted into a continuously unvaried current by adding a discharge current produced by lowering (or decreasing) the direct current voltage from V₁ to V₀, and the continuously unvaried current value i₀ is utilized for the inspection of an insulation property of the capacitor.

Therefore, according to the inspection method of the invention, the insulation property of a capacitor can be inspected in a shortened period of time (which is shorter than the aforementioned time t₀) by simple procedures comprising the steps of applying a direct current voltage V₁ to a capacitor to be inspected; lowering the direct current voltage V₁ to the voltage V₀ at a lapse of time t₁ to convert the electric current flowing in the capacitor into a continuously unvaried current; and determining the value i₀ of the continuously unvaried current.

For the reasons described above, according to the inspection method, a reliably stable value i₀ of the continuously unvaried current can be detected even when the time for the detection of the current value slightly deviates. Therefore, the inspection method of the invention enables to inspect an insulation property of a capacitor with high accuracy. The accuracy of the inspecttion can be further increased if the value of the continuously unvaried current is measured plural times and the measured values are averaged to obtain the current values i₀.

The inspection method of the invention preferably comprises a step of comparing the value i₀ of the continuously unvaried current with a lower limit i_{0L} of a leakage current which is predetermined for the capacitor to be inspected. As is described hereinbefore, it is generally accepted that the determined leakage current value i₀ of a capacitor should be as little as possible. However, it is sometimes desired that a group of capacitors have a leakage characteristic equivalent to each other. In this case, the obtained current value (leakage current value) i₀ can be compared with a predetermined lower limit (i_{0L}) of leakage current. The comparison of i₀ with i_{0L} is also effective to check whether or not the ampere meter works correctly.

In the inspection method of the invention, the value V₀ of the direct current to be applied to the capacitor can be the same as the predetermined voltage V₀ which is adopted in the aforementioned conventional method (A). The upper limit i_{0H} and lower limit i_{0L} of the leakage current to be compared with the value of the continuously unvaried current can be the same as the predetermined upper limit i_{0H} and lower limit i_{0L} which are adopted in the conventional method (A).

In other words, the inspection method of the present invention can be performed employing the direct current voltage V₀, upper limit i_{0H} and lower limit i_{0L} which are adopted in the inspection procedures according to the conventional method (A). If the conventional inspection method (A) has been not performed on the same type of the capacitor to be inspected, the direct current voltage V₀, upper limit i_{OH} and lower limit i_{0L} can be newly determined in the conventional method (A).

The voltage V₁ is set at a value generally within 1.001 to 2 times, preferably 1.001 to 1.5 times, as much as the voltage V₀.

The time t₁ is generally set at a time shorter than the time t₀ by 4 milliseconds or more. In other words, the time t₁ can be set at a time generally within 3 milliseconds to 10 seconds, preferably within 3 milliseconds to 1 second, more preferably within 3 to 500 milliseconds. The inspection of an insulation property can be performed within a shorter period of time than the period of time required for the inspection according to the method (A), if the time t₁ is set at a time shorter than the time to by 4 milliseconds or more.

As described hereinbefore, the inspection method of the invention comprises a procedure of lowering the value of the direct current voltage applied to the capacitor from V₁ to V₀. In this procedure, the lowered voltage V₀ can be a voltage within V₀ ± 0.3x(V₁-V₀), preferably within V₀ ± 0.2x(V₁-V₀)

Fig. 5 schematically shows another example of the waveform of a direct current voltage applied to a capacitor to be inspected in the inspection method of the invention, and Fig. 6 schematically shows another example of the waveform of an electric current flowing in the capacitor by the application of the direct current voltage shown in Fig. 5.

The value V₁ of the direct current voltage shown in Fig. 5 is set at a value lower than the value V₁ of the direct current voltage shown in Fig. 3. Therefore, when the direct current voltage V₁ is lowered to V₀ in Fig. 5, the value (i.e., amount) of the discharge current produced in the capacitor is less than the value of the discharge current produced in the case of Fig. 3. As a result, the period of time required for converting the electric current flowing in the capacitor into a continuously unvaried current is prolonged, as is shown in Fig. 6. In more detall, the electric current is converted into the continuously unvaried current at the time t₃ indicated in Fig. 6.

In Fig. 6, the determination of the current value i₀ can be made within a period from t₃ to t₀.

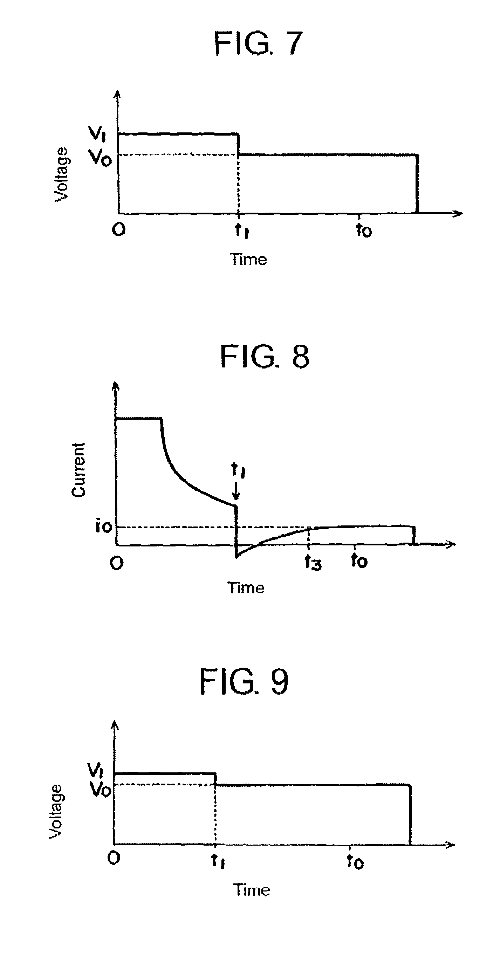

Fig. 7 schematically shows a further example of the waveform of a direct current voltage applied to a capacitor to be inspected in the inspection method of the invention, and Fig. 8 schematically shows a further example of the waveform of an electric current flowing in the capacitor by the application of the direct current voltage shown in Fig. 7.

The value V₁ of the direct current voltage shown in Fig. 7 is set at a value higher than the value V₁ of the direct current voltage shown in Fig. 3. Therefore, when the direct current voltage V₁ is lowered to V₀ in Fig. 7, the value (i.e., amount) of the discharge current produced in the capacitor is greater than the value of the discharge current produced in the case of Fig. 3. As a result, the period of time required for converting the electric current flowing in the capacitor into a continuously unvaried current is prolonged, as is shown in Fig. 8. Im more detail, the electric current is converted into the continuously unvaried current at the time t₃ indicated in Fig. 8.

In Fig. 8, the determination of the current value i₀ can be made within a period from t₃ to t₀.

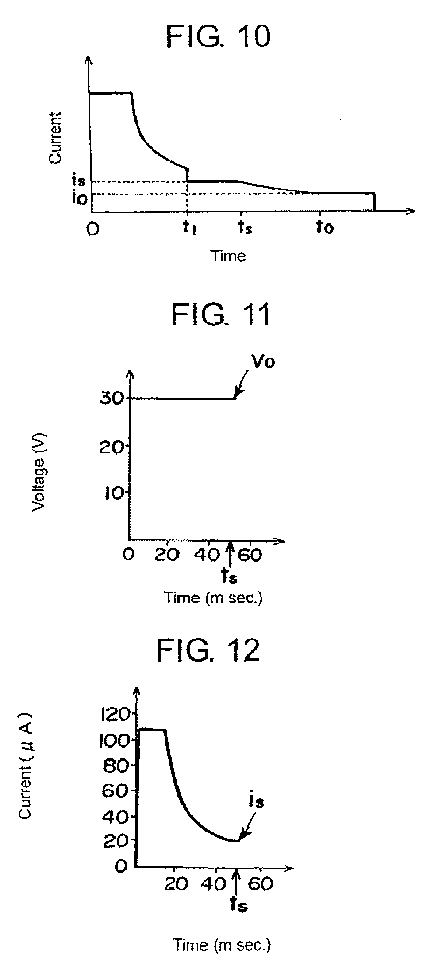

Fig. 9 schematically shows a still further example of the waveform of a direct current voltage applied to a capacitor to be inspected in the inspection method of the invention, and Fig. 10 schematically shows a still further example of the waveform of an electric current flowing in the capacitor by the application of the direct current voltage shown in Fig. 9.

As is understood from Fig. 9 and Fig. 10, the continuously unvaried current can be produced at any time between the time t₁ and the time t₀ which is prior to the time to in the inspection method of the invention, by adjusting the voltage V₁ and/or the time t₁ appropriately.

Fig. 10 further shows that the continuously unvaried current can be produced twice between the time t₁ and time tₛ and after the time t₀. If the continuously unvaried current can be produced twice or more after the direct current voltage is lowered from V₁ to V₀, the value iₛ of the first continuously unvaried current flowing from the time t₁ to the time tₛ should be compared with the predetermined upper limit i_{sH} (that is, a value relating to the leakage current) for inspecting an insulation property of the capacitor. In this procedure, a capacitor having been inspected is rejected if the value iₛ exceeds the upper limit i_{3H}, based on the assumption that a capacitor showing a value iₛ exceeding the upper limit i_{sH} at a lapse of time tₛ will show iₒ exceeding the upper limit i_{0H} when the time t₀ lapse. Still in this procedure, the current value iₛ determined for the first continuously unvaried current is preferably compared further with the lower limit i_{sL} relating to the leakage current.

In the above-described inspection procedures, the upper limit i_{sH} and lower limit i_{sL} to be compared with the value iₛ of the continuously unvaried current can be predetermined in the same manner as described in the aforementioned method (B). Accordingly, the inspection method of the present invention can be performed employing the direct current voltage V₀, upper limit i_{sH} and lower limit i_{sL} which are adopted in the inspection procedures according to the conventional method (B). If the conventional inspection method (B) has been not performed on the same type of the capacitor to be inspected, the direct current voltage V₀, upper limit i_{sH} and lower limit i_{sL}, can be newly determined in the conventional method (B).

In the inspection method of the invention described above, the voltage V₁ and time t₁ are preferably determined by the procedure comprising the below-mentioned steps 1) and 2).

Step 1) for applying an optionally determined direct current voltage V₂ higher than the voltage V₀ to a referential capacitor, whereby generating an electric current in the referential capacitor, and then lowering the direct current voltage V₂ to the voltage V₀ at a lapse of an optionally determined time t₂, and detecting a pattern of an electric current flowing in the referential capacitor.

The referential capacitor is an optionally selected capacitor from a group of practically acceptable capacitors prepared under the same specification.

The voltage V₂ is set at a value generally within 1.001 to 2 times, preferably 1.001 to 1.5 times, as much as the voltage V₀.

The time t₂ is generally set at a time shorter than the time to by 4 milliseconds or more. In other words, the time t₂ can be set at a time generally within 3 milliseconds to 10 seconds, preferably within 3 milliseconds to 1 second, more preferably within 3 to 500 milliseconds.

Step 2) for repeating a combination of the above-mentioned steps to find a combination of a direct current voltage V₂ and a time t₂ to give a pattern having a continuously unvaried electric current, and allotting the found combination of a direct current voltage V₂ and a time t₂ to a combination of the direct current voltage V₁ and the time t₁.

In the step 2), the "a continuously unvaried electric current" means that the current value is continuously within 0.75 to 1.25 times, preferably 0.80 to 1.20 times, more preferably 0.90 to 1.10 times, as much as a current value observed at the time of start of the unvaried electric current, within a period of time of 4 milliseconds or longer.

The appropriate combination of the voltage V₂ and time t₂ can be found out by repeating the above-mentioned step 1) varying the voltage V₂ but keeping the time t₂, or varying the time t₂ but keeping the voltage V₂, or varying both of voltage V₂ and time t₂.

For instance, the pattern of a continuously unvaried current flowing in the capacitor can be detected by setting the voltage V₂ at a voltage higher than the voltage V₀ by a small voltage value (such as a value of 0.01 to 0.5 V) and observing a pattern of an electric current produced by lowering the voltage V₂ to the voltage V₀. If a pattern of thus produced electric current is not a pattern of the continuously unvaried current, a slightly high voltage V₂ is set and the voltage V₂ is lowered to observe a pattern of an electric current. These procedures are repeated until a pattern of the continuously unvaried electric current is observed at a lapse of time t₂. Thus, the appropriate combination of the voltage V₂ and time t₂ is detected.

If the appropriate combination of the voltage V₁ and time t₁ is once detected, there is no need of repeatedly detecting an appropriate combination of the voltage V₁ and time t₁ to perform the inspection of an insulation property of capacitors having the same specification as that of the reference capacitor.

The present invention is further described by the following non-limiting examples.

### [Comparison Example]

An commercially available ceramic capacitor (or condenser) was inspected with reference to its insulation property by the below-mentioned procedures according to the conventional inspection method (B) under the following conditions:
Direct current voltage (V₀) predetermined for inspection of an insulation property of the ceramic capacitor: 30 V
Time (tₛ) predetermined for determination of a value (iₛ) of an electric current flowing in the capacitor: 50 milliseconds
Upper limit (i_{sB}) to be compared with the current value (iₛ): 25 µA
Lower limit (i_{sL}) to be compared with the current value (iₛ) : 15 µA.

The direct current voltage (30 V) was applied to the ceramic capacitor. At a lapse of 50 milliseconds, an electric current flowing in the capacitor was detected. The detected current value was 19 µA, which was between the upper limit 25 µA and the lower limit 15 µA. Therefore, it was confirmed that the inspection of the ceramic capacitor was successfully performed for 50 milliseconds.

Fig. 11 shows a waveform of a direct current voltage applied to the capacitor in the above-mentioned inspection method, and Fig. 12 shows a waveform of an electric current flowing in the capacitor by the application of the direct current voltage shown in Fig. 11.

### [Example according to the invention]

A ceramic capacitor prepared under the same specification as that of the above-mentioned commercially available ceramic capacitor was obtained.

First a direct current voltage of 30.1 V was applied to the capacitor. At a lapse of 20 milliseconds (which was tentatively predetermined), the voltage was lowered to 30 V, and the electric current flowing in the capacitor after the lowering of the voltage was observed to examine if a continuously unvaried current was produced. Thereafter, a direct current voltage of 30.2 V was applied to the capacitor. At a lapse of 20 milliseconds, the same observation was performed. The same procedures except that the applied direct current voltage was increased by 0.1 V were repeated until the production of a continuously unvaried current was confirmed. As a result, it was confirmed that the continuously unvaried current of approx. 19 µA was produced during 30 to 50 milliseconds when a direct current voltage of 30.5 V was applied and the voltage was lowered to 30 V at a lapse of the predetermined 20 milliseconds

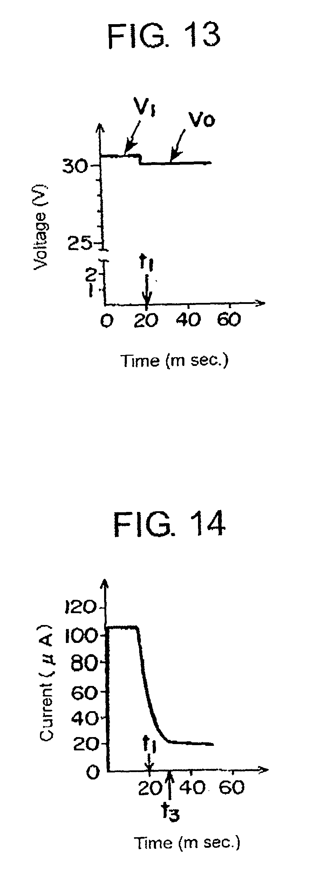

Fig. 13 shows a waveform of a direct current voltage applied to the capacitor, and Fig. 14 shows a waveform of an electric current flowing in the capacitor by the application of the direct current voltage shown in Fig. 13.

Thereafter, 100 ceramic capacitors prepared under the same specification as that of the above-mentioned commercially available ceramic capacitor were collected.

To each of the ceramic capacitors was applied a direct current voltage of 30.5 V (V₁). At a lapse of 20 milliseconds (t₁), the voltage was lowered to 30 V, and the electric current flowing in the capacitor at a time (t₃) of 10 milliseconds after the lowering of the voltage was observed to confirm that a continuously unvaried current was produced. It was confirmed that all of the inspected ceramic capacitors gave values of the continuously unvaried current between 16 µA and 22 µA at the time t₃·

Therefore, it was confirmed the inspection of the ceramic capacitor was complete for a period of 30 milliseconds, which is 60% of the period of time (50 milliseconds) required for performing the conventional inspection method (B) described in the above-mentioned Comparison Example.

## Claims

1. A method for inspecting an insulation property of a capacitor, which comprises the steps of :
applying a direct current voltage V₁ higher than a voltage V₀ to a capacitor to be inspected, said voltage V₀ being predetermined for inspection of an insulation property of the capacitor, whereby generating an electric current in the capacitor;
lowering the direct current voltage V₁ to the voltage V₀ at a lapse of a time t₁, whereby converting the electric current in the capacitor into a continuously unvaried electric current;
determining a value i₀ of the continuously unvaried electric current; and
comparing the value i₀ with an upper limit of a leakage current which is predetermined for the capacitor to be inspected,
provided that if the continuously unvaried electric current is observed twice or more after the lowering of the direct current voltage, a value is of the first continuously unvaried electric current is compared with an upper limit of a leakage current-relating value which is predetermined for the capacitor to be inspected.

2. The method for inspecting an insulation property of a capacitor according to claim 1, which further comprises the step of comparing the value i₀ with a lower limit of a leakage current which is predetermined for the capacitor to be inspected,
provided that if the continuously unvaried electric current is observed twice or more after the lowering of the direct current voltage, a value iₛ of the first continuously unvaried electric current is compared with a lower limit of a leakage current-relating value which is predetermined for the capacitor to be inspected.

3. The method for inspecting an insulation property of a capacitor according to claim 1 or claim 2, in which the direct current voltage V₁ and the time t₁ are determined by a method comprising the steps of:
applying an optionally determined direct current voltage V₂ higher than the voltage V₀ to a referential capacitor, whereby generating an electric current in the referential capacitor;
lowering the direct current voltage V₂ to the voltage V₀ at a lapse of an optionally determined time t₂, and detecting a pattern of an electric current flowing in the referential capacitor;
repeating a combination of the above-mentioned steps to find a combination of a direct current voltage V₂ and a time t₂ to give a pattern having a continuously unvaried electric current; and
allotting the found combination of a direct current voltage V₂ and is time t₂ to a combination of the direct current voltage V₁ and the time t₁.
